# EUROPEAN PATENT SPECIFICATION

(11) **EP 1 967 602 B1**
(45) Date of publication and mention of the grant of the patent: **03.07.2019**
(21) Application number: 08003022.4
(22) Date of filing: 19.02.2008
(51) Int. Cl.: C23C 14/08, C23C 14/02, C23C 14/30, C23C 28/00, C23C 14/24

(54) **Ceramic-coated member and production method thereof**
Keramikbeschichtetes Element und Verfahren zu seiner Herstellung
Élément à revêtement céramique et son procédé de production

(30) Priority: 20.02.2007 JP 2007039277
(43) Date of publication of application: 10.09.2008
(73) Proprietor: Kabushiki Kaisha Toshiba, Minato-ku, Tokyo 105-8001 (JP)
(72) Inventor: Ishiwata, Yutaka, Tokyo 105-8001 (JP); Fuse, Toshiaki, Tokyo 105-8001 (JP); Wada, Kunihiko, Tokyo 105-8001 (JP)
(74) Representative: Hoffmann Eitle

(56) References cited:
- EP-A1- 1 642 993
- EP-A1- 1 666 638
- EP-A2- 1 811 060
- EP-A2- 1 811 061
- WO-A1-00/09778
- WO-A2-2004/076704
- WO-A2-2007/037773
- WO-A2-2009/085572
- WO-A2-2009/085577
- US-A- 5 705 231
- US-A- 5 780 171
- US-A1- 2003 003 328
- US-A1- 2005 013 994
- US-A1- 2005 170 200
- US-A1- 2005 249 977

## Description

### CROSS-REFERENCE TO RELATED APPLICATIONS

This application is based upon and claims the benefit of priority from the prior Japanese Patent Application No. 2007-039277 filed on February 20, 2007.

### BACKGROUND

### 1. FIELD OF THE INVENTION

The present invention relates to a coated member which is coated with ceramic material by electron-beam physical vapor deposition and a manufacturing method thereof, and more particularly to a ceramic-coated member, which has a member for industrial gas turbines, jet engines and the like and exposed to high temperatures improved in heat resistance, oxidation resistance, heat cycle resistance and the like, and a manufacturing method thereof.

### 2. DESCRIPTION OF THE RELATED ART

High-temperature members such as rotor blades (blades), stator vanes (vanes), combustors and the like for industrial gas turbines, jet engines and the like are exposed to a combustion gas of exceeding 1000°C. Generally, such high-temperature members are made of a heat-resistant alloy called a nickel-base superalloy but their strength is deteriorated suddenly exceeds 1000°C. Therefore, these high-temperature members are controlled to a temperature of 950°C or below by cooling their front and rear surfaces with a cooling medium such as air, steam or the like. But, since a combustion efficiency and power generation efficiency can be improved by increasing the combustion gas temperature, the combustion gas temperatures of the industrial gas turbines, jet engines and the like of these years are kept increasing to 1300°C and further to 1500°C. Therefore, a conventional cooling method is hard to control the high-temperature members to a temperature of 950°C or below.

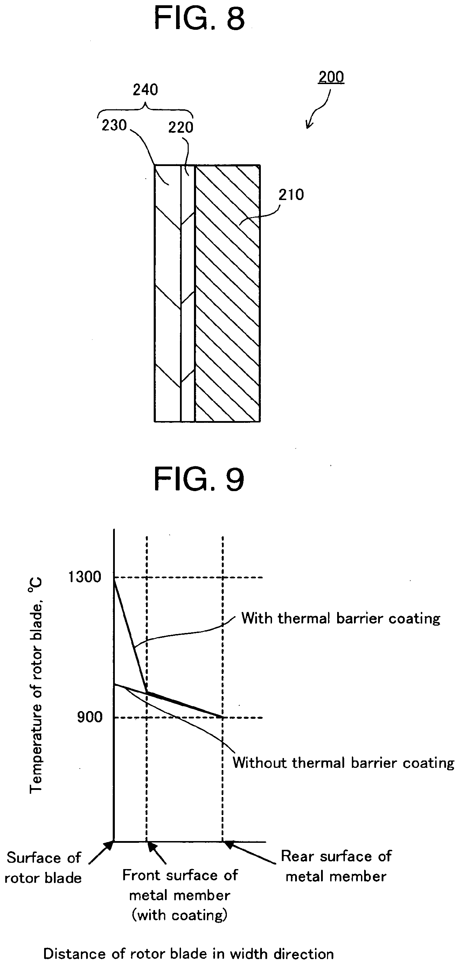

Fig. 8 shows a part of a sectional structure of a rotor blade 200 which is used for the latest industrial gas turbines and jet engines. Fig. 9 is a schematic view showing the effects of a thermal barrier coating.

As shown in Fig. 8, the rotor blade 200 has a metal layer 220 having excellent corrosion and oxidation resistance coated on a surface of a refractory metal member 210 and a ceramic layer 230 having a low thermal conductivity and an excellent thermal barrier characteristic coated on a surface of the metal layer 220. The metal layer 220 and the ceramic layer 230 function as a thermal barrier coating layer 240. A surface of the ceramic layer 230 is in contact with combustion gas, and a surface of the refractory metal member 210, which is on the other side of the thermal barrier coating layer 240, is in contact with a cooling medium.

As shown in Fig. 9, the rotor blade 200 is provided with a large temperature gradient by the ceramic layer 230 to retard a metal base material from having an increased temperature with an increase in temperature of the combustion gas to a high level. In Fig. 9, the horizontal axis indicates a distance from the surface of the rotor blade 200 shown in Fig. 8, which is in contact with the combustion gas, to the refractory metal member 210. The vertical axis indicates a temperature of the rotor blade 200. The ceramic material used for the ceramic layer 230 is desired to have a low thermal conductivity and excellent heat resistance, and zirconium oxide (ZrO₂) which is stabilized with yttrium oxide (Y₂O₃) is generally used extensively. This yttrium oxide-stabilized zirconium oxide has a thermal conductivity of about 2 W/(m·K), which is about 1/10 to 1/100 of the thermal conductivity of the metallic material. The yttrium oxide-stabilized zirconium oxide has a thermal conductivity which is low among the ceramic materials and can be lowered to about 1.4 W/(m·K) by forming a large number of pores in the coating film by plasma spraying at the time of thermal barrier coating.

But, the surface of the thermal barrier coating layer 240 is required to have excellent abrasion resistance and erosion resistance because it is hit by solid particles such as oxide scale at a high speed. Meanwhile, the surface of the metal layer 220 is required to have excellent oxidation resistance because an oxide layer grows and causes delamination of the ceramic layer 230. Besides, since the rotor blade 200 is exposed to a high temperature for a long time, a thermal stress is generated repeatedly because of a thermal expansion difference between the metal layer 220 and the ceramic layer 230 with the start and stop. And, the delamination of the ceramic layer 230 is accelerated. Therefore, it is required to relieve the thermal stress.

As described above, the thermal barrier coating which is applied to the high-temperature member such as the rotor blade 200 is demanded to have various characteristics, and the above demands are hardly satisfied by a simple combination of the metal layer and the ceramic layer. Accordingly, the thermal barrier coating layer is multilayered to share the functions of the individual layers, thereby satisfying the above demands.

For example, JP-A 2003-41358 discloses a metallic part having a multilayer structure of a barrier layer, a hot gas corrosion protection layer, a protection layer, a heat barrier layer and a flat and smooth layer. JP-A 2001-348655 discloses a gas turbine member which has a double-layered structure of a ceramic layer having a high strength and high toughness and a ceramic layer having high temperature stability. And, JP-A 2006-124226 discloses a ceramic part for a gas turbine, which has a close adhesion promoting layer, a stress relieving layer, a crack development preventive layer and a surface corrosion-resistant layer.

The coating on the above-described conventional high-temperature parts is formed by thermal spraying. For example, JP-A 2005-313644 also discloses metallic parts which have a thermal barrier coating formed by the electron-beam physical vapor deposition. This electron-beam physical vapor deposition forms the coating by growing the evaporated coating material on the substrate to obtain columnar ceramic structure and is excellent in a thermal stress relieving property in comparison with the case that the thermal spraying is performed.

US 2005/0013994 A1 on the other hand discloses a substrate coated with a MCrAlY bond coat,a first thermal stress relieving ceramic layer made of yttria stabilized zirconia and a second thermal barrier ceramic layer made of stabilized hafnia, with a concentration gradient interface between the two layers.

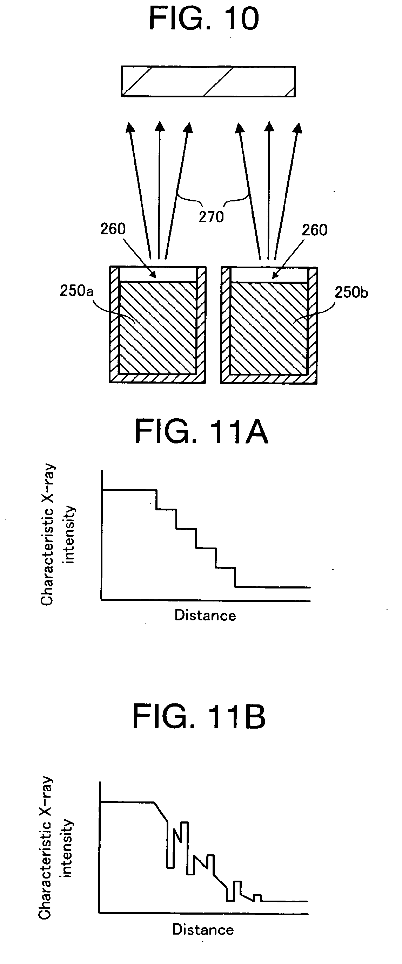

Fig. 10 shows a diagram for illustrating an overview of the electron-beam physical vapor deposition. Fig. 11A schematically shows a change in characteristic X-ray intensity (corresponding to the density of ceramic material A) in the thickness direction in the vicinity of an interface between a ceramic material A layer and a ceramic material B layer when the gradient composition layer of two types of ceramic materials (A, B) is formed by using a thermal spraying method. And, Fig. 11B is a diagram schematically showing a change in characteristic X-ray intensity (corresponding to the density of the ceramic material A) in the thickness direction in the vicinity of the interface between the ceramic material A layer and the ceramic material B layer when the gradient composition layer of two types of ceramic materials (A, B) is formed by the electron-beam physical vapor deposition.

For the electron-beam physical vapor deposition shown in Fig 10, two kind of ingots, namely evaporation targets 250a and 250b, are prepared, and the output of an electron beam 260 is gradually varied to control the evaporated quantity of vapor 270, thereby forming the gradient composition layer. In the gradient composition layer formed by the electron-beam physical vapor deposition, the characteristic X-ray intensity in the thickness direction in the vicinity of the interface between the ceramic material A layer and the ceramic material B layer has a considerably uneven intensity distribution as shown in Fig. 11B. Meanwhile, in the gradient composition layer formed by the thermal spraying method, the characteristic X-ray intensity in the thickness direction in the vicinity of the interface between the ceramic material A layer and the ceramic material B layer has a step-like intensity distribution as shown in Fig. 11A.

It is significant for the above-described multilayer coating to relieve a thermal stress due to adhesiveness between the individual coatings, consistency of a crystal structure and a thermal expansion difference and, for that, to have ideally a gradient composition structure that the composition of the interface between the individual coatings is continuously variable.

The thermal spraying which is a conventional thermal barrier coating method changes stepwise the compounding ratio of thermal spraying powder to provide a gradient composition and requires exchanging the thermal spraying powder every time the composition is changed. Therefore, as described above, the characteristic X-ray intensity in the thickness direction in the vicinity of the interface between the ceramic material A layer and the ceramic material B layer of the gradient composition layer becomes a step-like intensity distribution, and the composition cannot be changed continuously.

According to the conventional electron-beam physical vapor deposition, the vapor amount of an evaporation target with respect to the electron beam power and evaporating rate are not necessarily constant, and a time lag is also caused in evaporation of both the evaporation targets. Therefore, the characteristic X-ray intensity in the thickness direction in the vicinity of the interface between the ceramic material A layer and the ceramic material B layer of the gradient composition layer becomes to have a considerably uneven intensity distribution, and the composition cannot be changed continuously as described above.

### BRIEF SUMMARY OF THE INVENTION

The present invention provides a ceramic-coated member excelling in thermal barrier characteristic and heat cycle life and having a gradient composition structure with a continuously variable composition of an interface between individual coatings formed by electron beam physical vapor deposition, and a production method thereof.

According to an aspect of the present invention, there is provided a ceramic-coated member as defined in claim 1.

The "amount" is also referred to as "density" in the following.

According to another aspect of the present invention, there is provided, as defined in claim 4, a production method of a ceramic-coated member according to claim 1.

### BRIEF DESCRIPTION OF THE DRAWINGS

The present invention is described with reference to the drawings, which are provided for illustration only and do not limit the present invention in any respect.
Fig. 1 is a diagram showing a cross section of a ceramic-coated member of a first embodiment.
Fig. 2 is a sectional view showing an overview of electron-beam physical vapor deposition for producing the ceramic-coated member.
Fig. 3 is a diagram showing a cross section of a ceramic-coated member of a second embodiment.
Fig. 4 is a sectional view showing an overview of electron-beam physical vapor deposition for producing the ceramic-coated member.
Fig. 5 is a diagram showing a reflected electron image obtained by observing a cross section of a test piece 3 through an SEM in Example 3.
Fig. 6 is a diagram showing the results of measurement of element distribution in a boundary portion and its neighborhood of the test piece 3 conducted in Example 3.
Fig. 7 is a diagram showing a relationship between an angle θ formed by an interface between a zirconium oxide ingot and a hafnium oxide ingot with respect to the central axis of a columnar stacked body and a thickness of a gradient composition layer formed when an ingot having that angle is used.
Fig. 8 shows a part of a sectional structure of a rotor blade which is used for the latest industrial gas turbines and jet engines.
Fig. 9 is a schematic view showing the effects of a thermal barrier coating.
Fig. 10 is a diagram for illustrating an overview of the electron-beam physical vapor deposition.
Fig. 11A is a diagram schematically showing a change in characteristic X-ray intensity in the thickness direction in the vicinity of an interface between a ceramic material A layer and a ceramic material B layer when a gradient composition layer of two types of ceramic materials (A, B) is formed by using a thermal spraying method.
Fig. 11B is a diagram schematically showing a change in characteristic X-ray intensity in the thickness direction in the vicinity of the interface between the ceramic material A layer and the ceramic material B layer when a gradient composition layer of two types of ceramic materials (A, B) is formed by electron-beam physical vapor deposition.

### DETAILED DESCRIPTION OF THE INVENTION

Embodiments of the present invention will be described below with reference to the figures.

### (First embodiment)

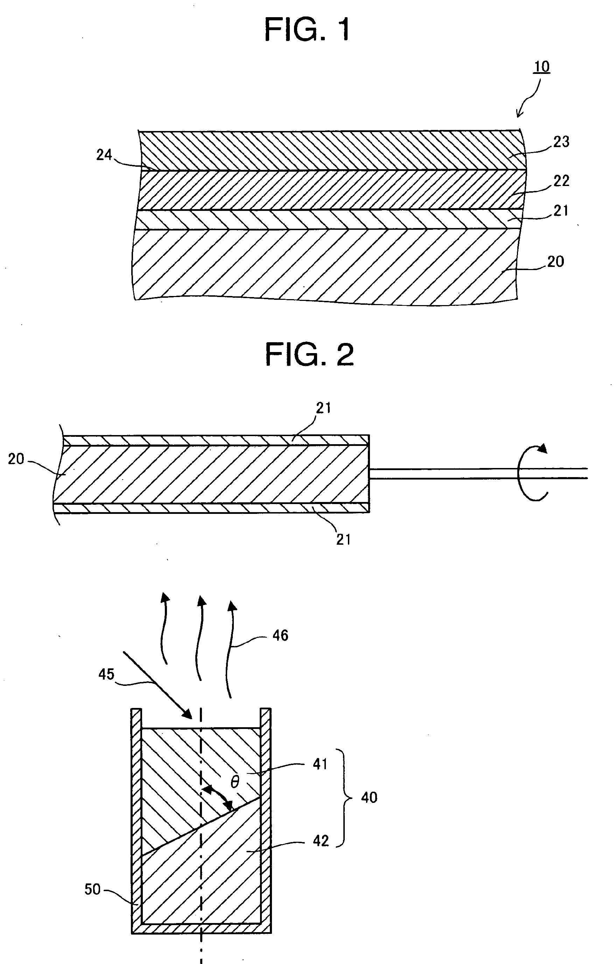

Fig. 1 is a diagram showing a cross section of a ceramic-coated member 10 of the first embodiment.

As shown in Fig. 1, the ceramic-coated member 10 has a base material 20, an oxidation resistant layer 21 stacked on the base material 20, a thermal stress relieving layer 22 stacked on the oxidation resistant layer 21, and a thermal barrier layer 23 stacked on the thermal stress relieving layer 22.

A boundary portion 24 and its neighborhood between the thermal stress relieving layer 22 and the thermal barrier layer 23 are configured such that a density of a ceramic material which forms the thermal stress relieving layer 22 decreases continuously from the thermal stress relieving layer 22 toward the thermal barrier layer 23 and a density of a ceramic material which forms the thermal barrier layer 23 increases continuously. The boundary portion 24 and its neighborhood function as a boundary layer.

For example, the base material 20 is comprised of a heat-resistant metallic material such as an Ni-base superalloy and a ceramic material such as silicon nitride. The base material 20 includes, for example, members to be exposed to a high-temperature combustion gas of industrial gas turbines, jet engines and the like but is not limited to them and may be a high-temperature member requiring a ceramic coating.

The oxidation resistant layer 21 is a coating which suppresses an oxide from generating on the surface of the base material 20 and improves its bonding property to the thermal stress relieving layer 22 and is comprised of a metallic material excelling in corrosion resistance, oxidation resistance and crack propagation resistance. The oxidation resistant layer 21 is formed of, for example, a Ni-base alloy, a Co-base alloy and an Ni-Co-base alloy to which Cr, Al and Y are added at a prescribed ratio. The oxidation resistant layer 21 is formed on the surface of the base material 20 by plasma spraying or the like.

The thermal stress relieving layer 22 is a coating formed of a ceramic material having a thermal expansion coefficient larger than that of the thermal barrier layer 23. As a ceramic material which forms the coating, for example, a stabilized zirconium oxide-based ceramic material having zirconium oxide (ZrO₂) as a main component is used. To the zirconium oxide is added as a stabilizing agent, for example, an oxide of a rare-earth element such as yttria (Y₂O₃), ceria (Ce₂O₃) or the like.

The thermal barrier layer 23 is a coating formed of a ceramic material having excellent heat resistance and low thermal conductivity. As a ceramic material forming the coating, for example, a stabilized hafnium oxide-based ceramic material having hafnium oxide (HfO₂) as a main component is used. To the hafnium oxide is also added as a stabilizing agent, for example, an oxide of a rare-earth element such as yttria (Y₂O₃), ceria (Ce₂O₃) or the like.

In the boundary portion 24 and its neighborhood between the thermal stress relieving layer 22 and the thermal barrier layer 23, the density of the zirconium oxide forming the thermal stress relieving layer 22 decreases continuously and the density of the hafnium oxide forming the thermal barrier layer 23 increases continuously from the thermal stress relieving layer 22 toward the thermal barrier layer 23. In other words, the boundary portion 24 and its neighborhood between the thermal stress relieving layer 22 and the thermal barrier layer 23 form a gradient composition layer which has the densities of zirconium oxide and hafnium oxide changed continuously in the thickness direction. Considering the generation of, for example, a thermal stress, the thickness of the gradient composition layer is preferably about 1/4 of the thickness of the ceramic layer which is formed of the thermal stress relieving layer 22 and the thermal barrier layer 23. Meanwhile, considering the thermal barrier characteristic, the thickness of the gradient composition layer is preferably about 1/2 of the thickness of the ceramic layer which is formed of the thermal stress relieving layer 22 and the thermal barrier layer 23. The thickness of the gradient composition layer is not limited to the above but may be determined appropriately in response to the demands for the base material 20.

A production method of the ceramic-coated member 10 will be described below with reference to Fig. 2.

Fig. 2 is a sectional view showing an overview of electron-beam physical vapor deposition (EB-PVD) for producing the ceramic-coated member 10.

First, the oxidation resistant layer 21 formed of the above-described metallic material is formed on a surface of the base material 20 by plasma spraying or the like.

Subsequently, the thermal stress relieving layer 22 and the thermal barrier layer 23 which are formed on the oxidation resistant layer 21 are formed by the electron-beam physical vapor deposition. A method of forming the thermal stress relieving layer 22 and the thermal barrier layer 23 is concretely described below.

The electron-beam physical vapor deposition forms a ceramic coating on a surface of the oxidation resistant layer 21 which is heated to a high temperature by irradiating an electron beam 45 to an ingot 40, which is formed of ceramic in vacuum, to melt the ingot surface so to produce the vapor 46 of ingot material. At this time, the base material 20 is rotated in a prescribed direction at a constant speed with its central axis determined as the rotation axis such that the surface of the oxidation resistant layer 21 can be uniformly ceramic-coated as shown in Fig. 2. For example, in a case where this method is used for ceramic coating, a coating having a thickness of 200 to 300 µm is generally formed at a coating speed of about 100 µm/h (a coating thickness formed in one hour). Meanwhile, the rotation speed of the base material 20 is set to about 10 rpm (rotations per minute). In other words, the coating thickness per rotation becomes about 0.17 µm, and in a case where the base material 20 is rotated to perform coating, a good gradient composition layer can be formed regardless of a portion of the base material 20.

The ingot 40 is placed in a water-cooled crucible 50 with a zirconium oxide ingot 41 and a hafnium oxide ingot 42 columnarly stacked such that the zirconium oxide ingot 41 is evaporated first. And, the ingot 40 is configured so that the interface between the zirconium oxide ingot 41 and the hafnium oxide ingot 42 has a prescribed angle θ with respect to the central axis of the columnar stacked body.

Here, the prescribed angle θ is preferably 45° to 85°. This angle θ is preferable because if it is less than 45°, the gradient composition layer has a thickness larger than the required thickness. In other words, the coating as a whole has a greater thickness, the film forming time period becomes long, and the coating tends to be delaminated. If the coating thickness as a whole is previously determined, the required thickness of the thermal barrier layer becomes thin. Meanwhile, if that angle exceeds 85°, the effect of providing the interface with the angle is impaired, and the continuous gradient composition cannot be formed.

As described above, the interface between the zirconium oxide ingot 41 and the hafnium oxide ingot 42 is configured to have the prescribed angle θ with respect to the central axis of the columnar stacked body, so that the vapor 46 of the composition containing both components zirconium oxide and hafnium oxide can be formed when that portion becomes the vapor 46. At the time when the ingot 40 is evaporated at the portion having the prescribed angle θ, the component composition of the vapor 46 has the density of the hafnium oxide increased continuously as the density of the zirconium oxide decreases continuously. Thus, between the thermal stress relieving layer 22 and the thermal barrier layer 23 is formed the gradient composition layer in that the density of the zirconium oxide forming the thermal stress relieving layer 22 decreases continuously and the density of the hafnium oxide forming the thermal barrier layer 23 increases continuously from the thermal stress relieving layer 22 toward the thermal barrier layer 23.

Adjustment of the above-described prescribed angle θ allows adjustment of the thickness of the gradient composition layer and the density gradient of the zirconium oxide and the hafnium oxide in the gradient composition layer. Besides, the stacked quantity of the zirconium oxide ingot 41 or the hafnium oxide ingot 42 at a portion other than the portion contacted at the prescribed angle θ in the ingot 40 can be adjusted to control the thickness of the thermal stress relieving layer 22 or the thermal barrier layer 23. Depending on the characteristics such as heat cycle life, thermal barrier characteristic, thermal shock resistance and the like which are required for the base material 20 to be coated, a coating can be applied by appropriately adjusting the prescribed angle θ in the ingot 40 and the stacked quantity of the zirconium oxide ingot 41 or the hafnium oxide ingot 42 at the portion other than the portion contacted at the prescribed angle θ.

As described above, the boundary portion 24 and its neighborhood between the thermal stress relieving layer 22 and the thermal barrier layer 23 of the ceramic-coated member 10 of the first embodiment can be formed as the gradient composition layer where the density of the zirconium oxide which forms the thermal stress relieving layer 22 is decreased continuously and the density of the hafnium oxide which forms the thermal barrier layer 23 is increased continuously from the thermal stress relieving layer 22 toward the thermal barrier layer 23. Thus, the concentration of a thermal stress in the contacted part of the coatings of the different materials is relieved, and the heat cycle characteristic can be improved substantially.

A surface of the ceramic-coated member 10 is formed of the thermal barrier layer 23 which is formed of hafnium oxide having excellent heat resistance and low thermal conductivity, and the metal layer side is formed of the thermal stress relieving layer 22 which is formed of zirconium oxide having low thermal conductivity and a thermal expansion coefficient larger than that of the hafnium oxide and stacked on the thermal barrier layer 23. Thus, it becomes possible to maintain the excellent thermal barrier characteristic even if the ceramic-coated member 10 is used at a high temperature for a long time.

The above-described ceramic-coated member 10 having the gradient composition layer (the boundary portion 24 and its neighborhood) can be produced by using the ingot 40 having the zirconium oxide ingot 41 and the hafnium oxide ingot 42 stacked in a columnar form such that the first evaporating side becomes the zirconium oxide ingot 41 by the electron-beam physical vapor deposition and the interface between the zirconium oxide ingot 41 and the hafnium oxide ingot 42 determined to have a prescribed angle θ with respect to the central axis of the columnar stacked body.

### (Second embodiment)

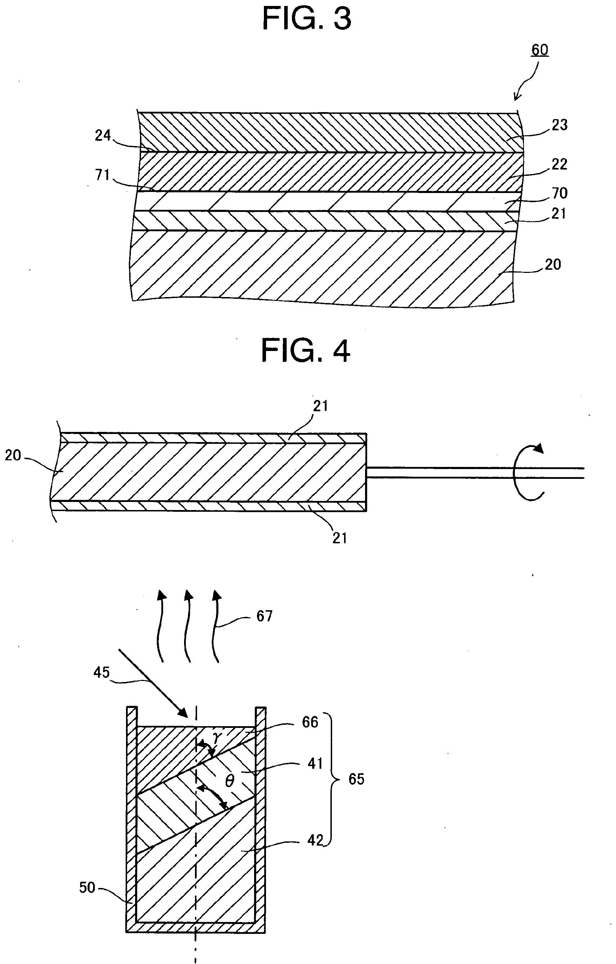

Fig. 3 is a diagram showing a cross section of a ceramic-coated member 60 of the second embodiment. Like component parts corresponding to those of the ceramic-coated member 10 of the first embodiment are denoted by like reference numerals, and overlapped descriptions will be omitted or simplified.

As shown in Fig. 3, the ceramic-coated member 60 has the base material 20, the oxidation resistant layer 21 which is laminated on the base material 20, an oxygen barrier layer 70 which is laminated on the oxidation resistant layer 21, the thermal stress relieving layer 22 which is laminated on the oxygen barrier layer 70, and the thermal barrier layer 23 which is laminated on the thermal stress relieving layer 22.

In a boundary portion 71 and its neighborhood between the oxygen barrier layer 70 and the thermal stress relieving layer 22, it is configured such that the density of a ceramic material which forms the oxygen barrier layer 70 decreases continuously and the density of a ceramic material which forms the thermal stress relieving layer 22 increases continuously from the oxygen barrier layer 70 toward the thermal stress relieving layer 22. Besides, in the boundary portion 24 and its neighborhood between the thermal stress relieving layer 22 and the thermal barrier layer 23, the density of the ceramic material which forms the thermal stress relieving layer 22 decreases continuously and the density of a ceramic material which forms the thermal barrier layer 23 increases continuously from the thermal stress relieving layer 22 toward the thermal barrier layer 23. The boundary portion 71 and its neighborhood function as a boundary layer.

The oxygen barrier layer 70 is a coating formed of a ceramic material which is excellent in prevention of oxygen permeation from the outside toward the oxidation resistant layer 21 and has a thermal expansion coefficient larger than those of the ceramic material having, as a main component, zirconium oxide which forms the thermal stress relieving layer 22 and that of the ceramic material having, as a main component, hafnium oxide which forms the thermal barrier layer 23. As the ceramic material which forms the coating, for example, an aluminum oxide-based ceramic material which has aluminum oxide (Al₂O₃) as a main component is used.

In the boundary portion 71 and its neighborhood between the oxygen barrier layer 70 and the thermal stress relieving layer 22, the density of the aluminum oxide which forms the oxygen barrier layer 70 decreases continuously and the density of the zirconium oxide which forms the thermal stress relieving layer 22 increases continuously from the oxygen barrier layer 70 toward the thermal stress relieving layer 22. In other words, the boundary portion 71 and its neighborhood between the oxygen barrier layer 70 and the thermal stress relieving layer 22 form a gradient composition layer where the densities of aluminum oxide and zirconium oxide change continuously in the thickness direction. Besides, in the boundary portion 24 and its neighborhood between the thermal stress relieving layer 22 and the thermal barrier layer 23, the density of the zirconium oxide which forms the thermal stress relieving layer 22 decreases continuously and the density of the hafnium oxide which forms the thermal barrier layer 23 increases continuously from the thermal stress relieving layer 22 toward the thermal barrier layer 23. In other words, the boundary portion 24 and its neighborhood between the thermal stress relieving layer 22 and the thermal barrier layer 23 form a gradient composition layer where the densities of zirconium oxide and hafnium oxide change continuously in the thickness direction.

A production method of the ceramic-coated member 60 is described with reference to Fig. 4.

Fig. 4 is a sectional view showing an overview of electron-beam physical vapor deposition for production of the ceramic-coated member 60.

First, the oxidation resistant layer 21 formed of the above-described metallic material is formed on a surface of the base material 20 by plasma spraying or the like.

Subsequently, the oxygen barrier layer 70, the thermal stress relieving layer 22 and the thermal barrier layer 23 are formed on the oxidation resistant layer 21 by the electron-beam physical vapor deposition. A method of forming the oxygen barrier layer 70, the thermal stress relieving layer 22 and the thermal barrier layer 23 is specifically described below.

The electron-beam physical vapor deposition is performed by irradiating an electron beam 45 to an ingot 65 which is formed of ceramic in vacuum to melt the ingot surface so as to produce the vapor 67 of ingot material, thereby forming a ceramic coating on a surface of the oxidation resistant layer 21 which is heated to a high temperature. At this time, the base material 20 is rotated in a prescribed direction at a constant speed with the central axis of the base material 20 determined as the rotation axis such that the surface of the oxidation resistant layer 21 can be uniformly ceramic-coated as shown in Fig. 4.

The ingot 65 is placed in a water-cooled crucible 50 by columnarly stacking an aluminum oxide ingot 66, the zirconium oxide ingot 41 and the hafnium oxide ingot 42 in this order such that the aluminum oxide ingot 66 is evaporated first. And, an interface between the aluminum oxide ingot 66 and the zirconium oxide ingot 41 and an interface between the zirconium oxide ingot 41 and the hafnium oxide ingot 42 are configured to have prescribed angles θ and γ with respect to the central axis of the columnar stacked body.

Here, the prescribed angles θ and γ are preferably 45° to 85°. The prescribed angles θ are γ are preferable because if they are less than 45°, the gradient composition layer has an increased thickness and if they exceed 85°, the effect that the interface is provided with the angle is impaired, and a continuous gradient composition cannot be formed. Since this gradient composition layer has high thermal conductivity, the gradient composition layer is desired to be thin.

As described above, the interface between the aluminum oxide ingot 66 and the zirconium oxide ingot 41 is configured to have the prescribed angle γ with respect to the central axis of the columnar stacked body, so that the vapor 67 having a composition containing both components, the aluminum oxide and the zirconium oxide, can be formed at the time when the interface becomes the vapor 67. The component composition of the vapor 67 at the time when the ingot 65 at the portion having the prescribed angle γ is evaporated has the density of the aluminum oxide decreased continuously as the density of the zirconium oxide increases continuously. Thus, between the oxygen barrier layer 70 and the thermal stress relieving layer 22 is formed the gradient composition layer in that the density of the aluminum oxide forming the oxygen barrier layer 70 decreases continuously and the density of the zirconium oxide forming the thermal stress relieving layer 22 increases continuously from the oxygen barrier layer 70 toward the thermal stress relieving layer 22.

The interface between the zirconium oxide ingot 41 and the hafnium oxide ingot 42 is configured to have the prescribed angle θ with respect to the central axis of the columnar stacked body, so that the vapor 67 having a composition containing both components, the zirconium oxide and the hafnium oxide, can be formed at the time when the interface becomes the vapor 67. The component composition of the vapor 67 when the ingot 65 of the portion having the prescribed angle θ has the density of the zirconium oxide decreased continuously and the density of the hafnium oxide increased continuously. Thus, the gradient composition layer is formed between the thermal stress relieving layer 22 and the thermal barrier layer 23, in which the density of the zirconium oxide which forms the thermal stress relieving layer 22 decreases continuously and the density of the hafnium oxide which forms the thermal barrier layer 23 increases continuously from the thermal stress relieving layer 22 toward the thermal barrier layer 23.

Adjustment of the above-described prescribed angles θ, γ allows adjustment of the thickness of the gradient composition layer, the density gradient of the aluminum oxide and the zirconium oxide in the gradient composition layer, and the density gradient of the zirconium oxide and the hafnium oxide. Besides, the stacked quantity of the individual ingots 41, 42, 66 other than the portions contacted at the prescribed angles θ, γ in the ingot 65 can be adjusted to adjust the thickness of the oxygen barrier layer 70, the thermal stress relieving layer 22 and the thermal barrier layer 23. Depending on the characteristics, for example, heat cycle life, thermal barrier characteristic, thermal shock resistance and the like which are required for the base material 20 to be coated, the coating can be applied by appropriately adjusting the prescribed angles θ, γ in the ingot 40 and the stacked quantity of the aluminum oxide ingot 66, the zirconium oxide ingot 41 or the hafnium oxide ingot 42 at the portion other than the portions contacted at the prescribed angles θ, γ.

As described above, according to the ceramic-coated member 60 of the second embodiment, the boundary portion 71 and its neighborhood between the oxygen barrier layer 70 and the thermal stress relieving layer 22 can be formed as the gradient composition layer where the density of the aluminum oxide which forms the oxygen barrier layer 70 is decreased continuously and the density of the zirconium oxide which forms the thermal stress relieving layer 22 is increased continuously from the oxygen barrier layer 70 toward the thermal stress relieving layer 22. Thus, the concentration of a thermal stress in the contacted part of the coatings of the different materials is relieved, and the heat cycle characteristic can be improved substantially.

And, the boundary portion 24 and its neighborhood between the thermal stress relieving layer 22 and the thermal barrier layer 23 can be formed as the gradient composition layer where the density of the zirconium oxide which forms the thermal stress relieving layer 22 decreases continuously and the density of the hafnium oxide which forms the thermal barrier layer 23 increases continuously from the thermal stress relieving layer 22 toward the thermal barrier layer 23. Thus, the concentration of a thermal stress in the contacted part of the coatings of the different materials is relieved, and the heat cycle characteristic can be improved substantially.

A surface of the ceramic-coated member 10 is formed of the thermal barrier layer 23 which is formed of hafnium oxide having excellent heat resistance and low thermal conductivity, the thermal stress relieving layer 22 which is formed of zirconium oxide having low thermal conductivity and a thermal expansion coefficient larger than that of the hafnium oxide is formed on the metal layer side of the thermal barrier layer 23, and the oxygen barrier layer 70 which is formed of the aluminum oxide having a thermal expansion coefficient larger than that of the zirconium oxide is formed on the metal layer side of the thermal stress relieving layer 22. Accordingly, even if the ceramic-coated member 10 is used at a high temperature for a long time, it maintains the excellent thermal barrier characteristic and has the excellent heat cycle characteristic.

The above-described ceramic-coated member 60 having the gradient composition layer (the boundary portions 24, 71 and their neighborhoods) can be produced by using the ingot 65 which has the aluminum oxide ingot 66, the zirconium oxide ingot 41 and the hafnium oxide ingot 42 stacked in this order in a columnar form such that the aluminum oxide ingot 66 is evaporated first by the electron-beam physical vapor deposition, and the interface between the aluminum oxide ingot 66 and the zirconium oxide ingot 41 and the interface between the zirconium oxide ingot 41 and the hafnium oxide ingot 42 have the prescribed angles θ, γ with respect to the central axis of the columnar laminated body.

It is described below that the ceramic-coated member according to the invention, which is coated with ceramic using the ingot which has the interface of the individual ingots of the ceramic described above determined to have 45° to 85° with respect to the central axis of the columnar stacked body, has an excellent heat cycle characteristic.

### (Example 1)

A production method of test pieces 1 used in Example 1 is described with reference to a sectional view showing an overview of the electron-beam physical vapor deposition for the production of the ceramic-coated member 10 shown in Fig. 2.

The oxidation resistant layer 21 which was a coating having a thickness of about 100 µm and formed of an Ni-Co-base alloy having excellent corrosion resistance and oxidation resistance was formed by plasma spraying on the surfaces of a disk-shaped base material 20 having a diameter of 2.54 cm (1 inch) and a thickness of 5 mm and made of a Ni-base superalloy.

The base material 20 on which the oxidation resistant layer 21 was formed was attached to be rotatable with the center of the disk-shaped base material 20 determined as the rotation axis within the coating chamber of an electron-beam physical vapor deposition apparatus. The base material 20 was rotated at about 10 rpm. The zirconium oxide ingot 41 and the hafnium oxide ingot 42 were stacked in a columnar shape in the water-cooled crucible 50 within the coating chamber such that the zirconium oxide ingot 41 was evaporated first. It was determined that the interface between the zirconium oxide ingot 41 and the hafnium oxide ingot 42 became 85° with respect to the central axis of the columnar stacked body.

After the coating chamber was evacuated, the electron beam 45 was irradiated to the surface of the zirconium oxide ingot 41 inserted into the water-cooled crucible 50 to melt the zirconium oxide so as to generate the vapor 46 of ingot material, thereby forming the thermal stress relieving layer 22 of the zirconium oxide on the surface of the oxidation resistant layer 21. Subsequently, the ingot 40 was melted gradually to evaporate, and the area including the interface between the zirconium oxide ingot 41 and the hafnium oxide ingot 42 was exposed to the electron beam 45 to generate the vapor 46 containing both of the zirconium oxide and the hafnium oxide, thereby forming a gradient composition layer in the boundary portion 24 and its neighborhood between the thermal stress relieving layer 22 and the thermal barrier layer 23. In the process of forming the above-described thermal stress relieving layer 22 and gradient composition layer, the base material 20 was kept at a temperature of 850 to 900°C.

Besides, the ingot 40 was melted to evaporate so as to reach the area formed of only the hafnium oxide ingot 42, and the hafnium oxide was melted to generate the vapor 46 so as to form the thermal barrier layer 23 of the hafnium oxide. In the process of forming the thermal barrier layer 23, the base material 20 was kept at a temperature of 900 to 950°C.

The electron beam 45 was stopped immediately before the hafnium oxide ingot 42 was completely evaporated and consumed.

The thermal stress relieving layer 22 formed by the above-described electron-beam physical vapor deposition had a thickness of about 200 µm, the gradient composition layer formed in the boundary portion 24 and its neighborhood had a thickness of about 24 µm, and the thermal barrier layer 23 had a thickness of about 100 µm.

The test pieces 1 produced by the above-described method were used to conduct a heat cycle test. In the heat cycle test, the individual test pieces 1 were placed and heated in an electric furnace kept at a temperature of 1100°C for 30 minutes and left in the atmosphere to cool to a temperature of 100°C. Subsequently, the test piece 1 having the temperature of 100°C was left standing in the electric furnace for 30 minutes and heated, and then left standing in the atmosphere until the temperature became 100°C. Thus, heating and cooling were repeated, and the number of repeated times until the ceramic coating layer formed of the test piece 1 was delaminated was measured.

Table 1 shows the results of the heat cycle test. In Table 1, the number of white and black circles indicates the number of test pieces undergone the heat cycle test under the same conditions. The white circle means that no damage was caused by the corresponding number of repeated times, and the black circle means that delamination or localized swelling was caused by the corresponding number of repeated times.

**[Table 1]**

| | Number of repetitions | 10 | 20 | 30 | 40 | 50 | 75 | 100 | 125 | 150 | 200 |
|---|---|---|---|---|---|---|---|---|---|---|---|
| E | Test piece 1 | ○○ | ○○ | ○○ | ○○ | ○○ | ○○ | ○● | ● | | |
| | Test piece 2 | ○○ | ○○ | ○○ | ○○ | ○○ | ○○ | ○○ | ○● | ● | |
| | Test piece 3 | ○○ | ○○ | ○○ | ○○ | ○○ | ○○ | ○○ | ○○ | ○○ | ○● |
| | Test piece 4 | ○○ | ○○ | ○○ | ○○ | ○○ | ○○ | ○○ | ○○ | ○○ | ○○ |
| CE | Test piece 5 | ○○ | ○○ | ○● | ○ | ○ | ● | | | | |
| | Test piece 6 | ●● | | | | | | | | | |

| | | | | | | | | | | | |
|---|---|---|---|---|---|---|---|---|---|---|---|
| E= Example, CE = Comparative Example | | | | | | | | | | | |

Two test pieces 1 were tested under the same conditions, and one of them had damage (delamination of coating) when the number of repeated times was 100 as shown in Table 1. When the number of repeated times was 125, the other test piece 1 had damage (delamination of coating).

### (Example 2)

Test pieces 2 used in Example 2 were produced by the same method as that used for the production of the test pieces 1 of Example 1 except that the ingot 40 which was formed to have the interface between the zirconium oxide ingot 41 and the hafnium oxide ingot 42 with an angle of 80° with respect to the central axis of the columnar stacked body was used.

In the produced test pieces 2, the thermal stress relieving layer 22 had a thickness of about 200 µm, the gradient composition layer formed in the boundary portion 24 and its neighborhood had a thickness of about 36 µm, and the thermal barrier layer 23 had a thickness of about 100 µm. The heat cycle test method and the measuring conditions were same as those of Example 1.

Two test pieces 2 were tested under the same conditions, and one of them had damage (delamination of coating) when the number of repeated times was 125 as shown in Table 1. When the number of repeated times was 150, the other test piece 2 had damage (delamination of coating).

### (Example 3)

Test pieces 3 used in Example 3 were produced by the same method as that used for the production of the test pieces 1 of Example 1 except that the ingot 40 which was formed to have the interface between the zirconium oxide ingot 41 and the hafnium oxide ingot 42 with an angle of 75° with respect to the central axis of the columnar stacked body was used.

In the produced test pieces 3, the thermal stress relieving layer 22 had a thickness of about 200 µm, the gradient composition layer formed in the boundary portion 24 and its neighborhood had a thickness of about 50 µm, and the thermal barrier layer 23 had a thickness of about 100 µm. The heat cycle test method and the measuring conditions were same as those of Example 1.

Two test pieces 3 were tested under the same conditions, and one of them had damage (delamination of coating) when the number of repeated times was 200 as shown in Table 1.

A cross section of the test piece 3 was observed through a scanning electron microscope (SEM). The boundary portion 24 and its neighborhood of the test piece 3 were measured for element distribution by an electron prove micro analyzer (EPMA). The results of the observation and element distribution measurement are described later.

### (Example 4)

A production method of test pieces 4 used in Example 4 is described with reference to a sectional view showing an overview of the electron-beam physical vapor deposition for the production of the ceramic-coated member 60 shown in Fig. 3.

An oxidation resistant layer 21 which is a coating having a thickness of about 100 µm and formed of an Ni-Co-base alloy having excellent corrosion resistance and oxidation resistance was formed on the surfaces of a disk-shaped base material 20 having a diameter of 2.54 cm (1 inch) and a thickness of 5 mm and formed of an Ni-base superalloy by plasma spraying.

The base material 20 on which the oxidation resistant layer 21 was formed was attached to be rotatable with the center of the disk-shaped base material 20 determined as the rotation axis within the coating chamber of an electron-beam physical vapor deposition apparatus. The base material 20 was rotated at about 10 rpm. An aluminum oxide ingot 66, the zirconium oxide ingot 41 and the hafnium oxide ingot 42 were stacked in this order in a columnar shape in the water-cooled crucible 50 within the coating chamber such that the aluminum oxide ingot 66 is evaporated first. It was determined that the interface between the aluminum oxide ingot 66 and the zirconium oxide ingot 41 and the interface between the zirconium oxide ingot 41 and the hafnium oxide ingot 42 became 85° with respect to the central axis of the columnar stacked body.

After the above-described coating chamber was evacuated, the electron beam 45 was irradiated to the surface of the aluminum oxide ingot 66 of the ingot 65 inserted into the water-cooled crucible 50 to melt the aluminum oxide so as to generate the vapor 67, thereby forming the oxygen barrier layer 70 of the aluminum oxide on the surface of the oxidation resistant layer 21. Subsequently, the ingot 65 was melted gradually to evaporate, and the area including the interface between the aluminum oxide ingot 66 and the zirconium oxide ingot 41 was exposed to the electron beam 45 to generate the vapor 67 containing both of the aluminum oxide and the zirconium oxide, thereby forming a gradient composition layer in the boundary portion 71 and its neighborhood. In the process of forming the above-described oxygen barrier layer 70 and gradient composition layer, the base material 20 was kept at a temperature of 600 to 800°C.

Besides, the ingot 65 was melted to evaporate so as to reach the area formed of only the zirconium oxide ingot 41, and the zirconium oxide was melted to generate the vapor 67 so as to form the thermal barrier layer 22 of the zirconium oxide. Subsequently, the ingot 40 was melted gradually to evaporate to reach the area including the interface between the zirconium oxide ingot 41 and the hafnium oxide ingot 42 and to generate the vapor 67 containing both of the zirconium oxide and the hafnium oxide, thereby forming a gradient composition layer in the boundary portion 24 and its neighborhood. In the process of forming the above-described thermal stress relieving layer 22 and gradient composition layer, the base material 20 was kept at a temperature of 700 to 900°C.

Besides, the ingot 65 was melted to evaporate so as to reach the area formed of only the hafnium oxide ingot 42, and the hafnium oxide was melted to generate the vapor 67 so as to form the thermal barrier layer 23 of the hafnium oxide. In the process of forming the thermal barrier layer 23, the base material 20 was kept at a temperature of 750 to 950°C.

And, the electron beam 45 was stopped immediately before the hafnium oxide ingot 42 was completely evaporated and consumed.

The oxygen barrier layer 70 formed by the above-described electron-beam physical vapor deposition had a thickness of about 20 µm, the thermal stress relieving layer 22 had a thickness of about 200 µm, the gradient composition layer had a thickness of about 24 µm, and the thermal barrier layer 23 had a thickness of about 100 µm.

The test pieces 4 produced by the above-described method were used to conduct a heat cycle test. The heat cycle test method and the measuring conditions were same as those of Example 1.

When the test pieces 4 were tested for the number of repeated times of 200, they had no damage as shown in Table 1.

### (Comparative Example 1)

Test pieces 5 used in Comparative Example 1 were produced by the same method as that used for the production of the test pieces 1 of Example 1 except that the ingot 40 which was formed to have the interface between the zirconium oxide ingot 41 and the hafnium oxide ingot 42 with an angle of 90° with respect to the central axis of the columnar stacked body was used. Here, the fact that the interface between the zirconium oxide ingot 41 and the hafnium oxide ingot 42 becomes 90° to the central axis of the columnar stacked body means that the interface between the zirconium oxide ingot 41 and the hafnium oxide ingot 42 is horizontal.

In the produced test pieces 5, the thermal stress relieving layer 22 had a thickness of about 100 µm, and the thermal barrier layer 23 had a thickness of about 100 µm. The heat cycle test method and the measuring conditions were same as those of Example 1.

Two test pieces 5 were tested under the same conditions, and one of them had damage (delamination of coating) when the number of repeated times was 30 as shown in Table 1. When the number of repeated times was 75, the other test piece 5 had damage (delamination of coating).

### (Comparative Example 2)

Test pieces 6 used in Comparative Example 2 were produced from an ingot which was prepared with the positions of the zirconium oxide ingot 41 and the hafnium oxide ingot 42 of the ingot 40 used in Example 1 reversed. In other words, the test pieces 6 were produced from the ingot which had the hafnium oxide ingot 42 and the zirconium oxide ingot 41 stacked in a columnar shape in the water-cooled crucible 50 such that the hafnium oxide ingot 42 was evaporated first. The ingot was formed such that the interface between the hafnium oxide ingot 42 and the zirconium oxide ingot 41 became 85° with respect to the central axis of the columnar stacked body.

After the above-described coating chamber was evacuated, the electron beam 45 was irradiated to the surface of the hafnium oxide ingot 42 of the ingot inserted into the water-cooled crucible 50 to melt the hafnium oxide so as to generate the vapor 46, thereby forming a coating layer of the hafnium oxide on the surface of the oxidation resistant layer 21. Subsequently, the ingot was melted gradually to evaporate so as to reach the area including the interface between the hafnium oxide ingot 42 and the zirconium oxide ingot 41 and to generate the vapor 46 containing both of the hafnium oxide and the zirconium oxide, thereby forming a gradient composition layer in the boundary portion 24 and its neighborhood. In the process of forming the above-described coating layer and gradient composition layer, the base material 20 was kept at a temperature of 750 to 950°C.

Besides, the ingot was melted to evaporate so as to reach the area formed of only the zirconium oxide ingot 41, and the zirconium oxide was melted to generate the vapor 46 so as to form the coating layer of the zirconium oxide. In the process of forming the coating layer, the base material 20 was kept at a temperature of 700 to 900°C.

And, the electron beam 45 was stopped immediately before the zirconium oxide ingot 41 was completely evaporated and consumed.

The coating layer of the hafnium oxide formed by the above-described electron-beam physical vapor deposition had a thickness of about 100 µm, the gradient composition layer had a thickness of about 24 µm, and the coating layer of the zirconium oxide had a thickness of about 200 µm.

The test pieces 6 produced by the above-described method were used to conduct a heat cycle test. The heat cycle test method and the measuring conditions were same as those of Example 1.

Two test pieces 6 were tested under the same conditions, and both of them had damage (delamination of coating) when the number of repeated times was 10 as shown in Table 1.

### (Summary of Example 1 to Example 4 and Comparative Example 1 to Comparative Example 2)

As shown in Table 1, it was found that the test pieces (test pieces 1 to 4) used in Example 1 to Example 4 of the invention had good heat cycle characteristic. It was also found from the results of Example 4 that better heat cycle characteristic could be obtained by disposing the oxygen barrier layer 70 formed of aluminum oxide between the oxidation resistant layer 21 and the thermal stress relieving layer 22.

It was found from the results of Example 1 to Example 3 of the invention that the heat cycle characteristic became better as the angle θ of the interface between the zirconium oxide ingot 41 and the hafnium oxide ingot 42 became smaller with respect to the central axis of the columnar stacked body. It is considered that the tendencies of the compositions to change discontinuously as shown in Fig. 11A and Fig. 11B were decreased to become continuous as the angle θ became smaller, and the concentration of the thermal stress in the interface between the different materials was lowered.

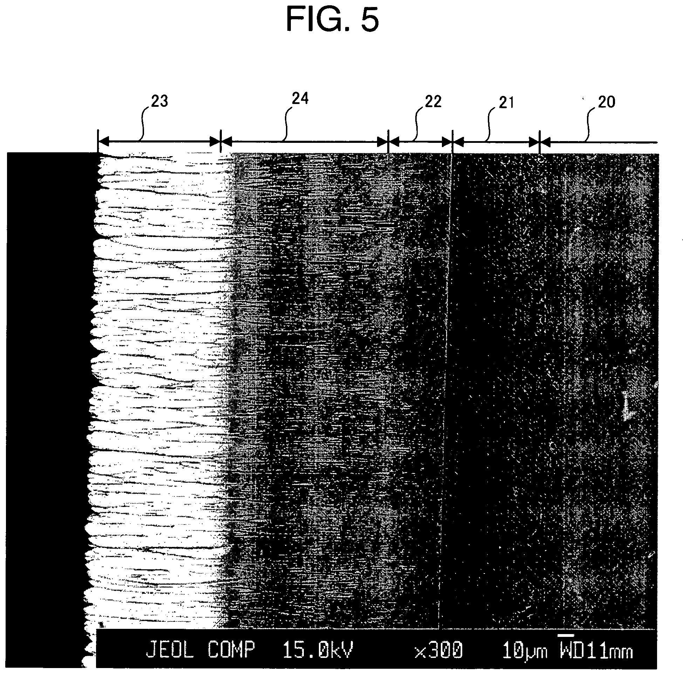

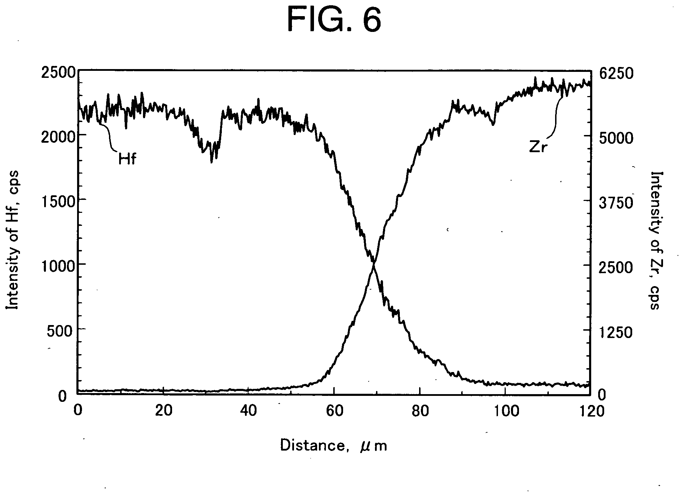

Fig. 5 shows a reflected electron image which is a result of observing a cross section of the test piece 3 of Example 3 by the SEM. Fig. 6 shows the results obtained by measuring the element distribution in the boundary portion 24 and its neighborhood of the test piece 3 performed in Example 3.

As shown in Fig. 5, it was found that the thermal barrier layer 23 and the thermal stress relieving layer 22 have therebetween the area having a structure different from the individual layers in the boundary portion 24 and its neighborhood. It was also found from the results of measuring the element distribution shown in Fig. 6 that in the boundary portion 24 and its neighborhood, the intensity of zirconium corresponding to the density of the zirconium oxide which formed the thermal stress relieving layer 22 decreased continuously from the thermal stress relieving layer 22 toward the thermal barrier layer 23, and the intensity of hafnium corresponding to the density of the hafnium oxide which formed the thermal barrier layer 23 increased continuously. In other words, it was found that the boundary portion 24 and its neighborhood formed the gradient composition layer where the densities of the zirconium oxide and the hafnium oxide changed continuously.

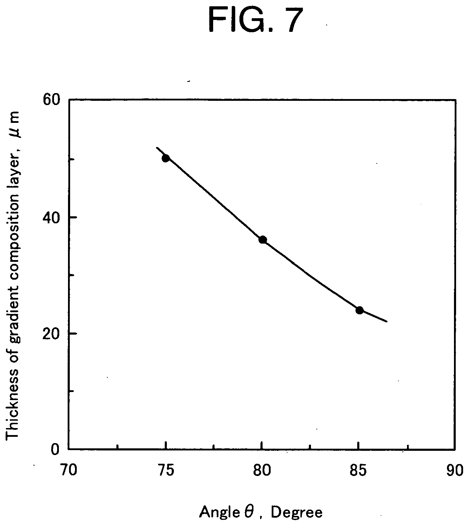

Fig. 7 shows a relationship between the angle θ formed by the interface between the zirconium oxide ingot 41 and the hafnium oxide ingot 42 with respect to the central axis of the columnar stacked body and the thickness of the gradient composition layer formed when the ingot 40 having that angle was used. The angle of 85° corresponds to the thickness of the gradient composition layer of the test piece 1, the angle of 80° corresponds to the thickness of the gradient composition layer of the test piece 2, and the angle of 75° corresponds to the thickness of the gradient composition layer of the test piece 3.

It is apparent from Fig. 7 that the boundary portion 24 and its neighborhood, namely the thickness of the gradient composition layer, can be controlled by varying the angle θ. It was also found that when the angle θ was increased, the gradient composition layer could be made thin, and when the angle θ was decreased, the gradient composition layer could be made thick. Thus, the gradient composition layer can be determined to have an appropriate thickness in compliance with, for example, the characteristics such as heat cycle life, thermal barrier characteristic and thermal shock resistance required by the ceramic-coated member.

The test piece 6 of Comparative Example 2 having the coating layer of zirconium oxide on the coating layer of hafnium oxide had a good gradient composition layer formed on both of the boundary portion and its neighborhood (not shown), but the heat cycle life was considerably inferior in comparison with the test pieces (test pieces 1 through 3) of Examples 1 through 3. It seems from the results that a thermal expansion coefficient (about 6×10⁻⁶/°C) of the hafnium oxide is small in comparison with a thermal expansion coefficient (about 10×10⁻⁶/°C) of the zirconium oxide or a thermal expansion coefficient (about 15×10⁻⁶/°C) of the metal base material, and a large thermal stress is generated in the coating layer of the hafnium oxide which is sandwiched between the coating layer of the zirconium oxide having a large thermal expansion coefficient and the metal base material. Therefore, it was found effective to select a material such that the thermal expansion coefficients of the individual layers decrease gradually from the side of the metal base material toward the surface in order to suppress the thermal stress generated in the individual layers similar to the test pieces (test pieces 1 through 3) of Example 1 through Example 3.

Although the invention has been described above by reference to the embodiments of the invention, the invention is not limited to the embodiments described above. It is to be understood that modifications and variations of the embodiments can be made without departing from the scope of the invention.

## Claims

1. A ceramic-coated member which is configured by laminating at least an oxygen barrier layer (70) having aluminium oxide as main component, a thermal stress relieving layer (22) of a first ceramic material having zirconium oxide as main component and a thermal barrier layer (23) of a second ceramic material having hafnium oxide as main component in this order on a base material made of metal or ceramic,
wherein the amount of the third ceramic material having aluminium oxide as main component which forms the oxygen barrier layer (70) decreases continuously and the amount of the first ceramic material which forms the thermal stress relieving layer (22) increases continuously from the oxygen barrier layer (70) toward the thermal stress relieving layer (22) in the boundary layer (24) between the oxygen barrier layer (70) and the thermal stress relieving layer (22); and
wherein the amount of the first ceramic material which forms the thermal stress relieving layer (22) decreases continuously and the amount of the second ceramic material which forms the thermal barrier layer (23) increases continuously from the thermal stress relieving layer (22) toward the thermal barrier layer (23) in a boundary layer between the thermal stress relieving layer (22) and the thermal barrier layer (23).

2. The ceramic-coated member according to claim 1, wherein an oxidation resistant layer (21) made of metal is interposed between the base material (20) and the oxygen barrier layer (70).

3. The ceramic-coated member according to claim 1 or 2, wherein the first ceramic material has a thermal expansion coefficient which is larger than that of the second ceramic material.

4. A production method of a ceramic-coated member according to claim 1 by electron-beam physical vapour deposition by use of an ingot (65),
wherein the ingot, which has the third ceramic material (66), the first ceramic material (41) and the second ceramic material (42) disposed by columnarly stacking in this order for enabling the third ceramic material (66) on the side to evaporate first and the interface between the third ceramic material (66) and the first ceramic material (41) and the interface between the first ceramic material (41) and the second ceramic material (42) configured with a prescribed angle with respect to the central axis of the columnar stacked body is used to form the oxygen barrier layer (70), the thermal stress relieving layer (22) and the thermal barrier layer (23).

5. The production method of a ceramic-coated member according to claim 4, wherein an oxidation resistant layer (21) made of metal is previously formed on a surface of the base material (20).

6. The production method of a ceramic-coated member according to claims 4 or 5, wherein the prescribed angle is in a range of 45° to 85°.

7. The production method of a ceramic-coated member according to any one of claims 4 through 6, wherein the first ceramic material has a thermal expansion coefficient which is larger than that of the second ceramic material.

8. The production method of a ceramic-coated member according to any one of claims 4 through 7, wherein the first ceramic material has zirconium oxide as a main component, and the second ceramic material has hafnium oxide as a main component.

9. The production method of a ceramic-coated member according to claim 4, wherein the third ceramic material has aluminum oxide as a main component.

## Patentansprüche

1. Keramikbeschichtetes Element, das ausgestaltet wird durch Laminieren mindestens einer Sauerstoffsperrschicht (70), die Aluminiumoxid als Hauptkomponente aufweist, einer thermischen Entspannungsschicht (22) eines ersten Keramikmaterials, das Zirkonoxid als Hauptkomponente aufweist, und einer thermischen Sperrschicht (23) eines zweiten Keramikmaterials, das Hafniumoxid als Hauptkomponente aufweist, in dieser Reihenfolge auf ein Basismaterial, das aus Metall oder Keramik hergestellt ist,
wobei die Menge des dritten Keramikmaterials, das Aluminiumoxid als Hauptkomponente aufweist, das die Sauerstoffsperrschicht (70) bildet, kontinuierlich abnimmt und die Menge des ersten Keramikmaterials, das die thermische Entspannungsschicht (22) bildet, kontinuierlich zunimmt, von der Sauerstoffsperrschicht (70) zur thermischen Entspannungsschicht (22) in der Grenzschicht (24) zwischen der Sauerstoffsperrschicht (70) und der thermischen Entspannungsschicht (22); und
wobei die Menge des ersten Keramikmaterials, das die thermische Entspannungsschicht (22) bildet, kontinuierlich abnimmt und die Menge des zweiten Keramikmaterials, das die thermische Sperrschicht (23) bildet, kontinuierlich zunimmt, von der thermischen Entspannungsschicht (22) zur thermischen Sperrschicht (23) in einer Grenzschicht zwischen der thermischen Entspannungsschicht (22) und der thermischen Sperrschicht (23).

2. Keramikbeschichtetes Element nach Anspruch 1, wobei eine oxidationsbeständige Schicht (21), die aus Metall hergestellt ist, zwischen dem Basismaterial (20) und der Sauerstoffsperrschicht (70) eingefügt ist.

3. Keramikbeschichtetes Element nach Anspruch 1 oder 2, wobei das erste Keramikmaterial einen Wärmeausdehnungskoeffizienten aufweist, der größer ist als jener des zweiten Keramikmaterials.

4. Herstellungsverfahren eines keramikbeschichteten Elements nach Anspruch 1 durch Elektronenstrahlaufdampfung durch Verwenden eines Ingots (65),
wobei der Ingot, der das dritte Keramikmaterial (66), das erste Keramikmaterial (41) und das zweite Keramikmaterial (42) angeordnet durch säulenförmiges Stapeln in dieser Reihenfolge, um zu ermöglichen, dass das dritte Keramikmaterial (66) auf der Seite als erstes verdampft, und die Schnittstelle zwischen dem dritten Keramikmaterial (66) und dem ersten Keramikmaterial (41) und die Schnittstelle zwischen dem ersten Keramikmaterial (41) und dem zweiten Keramikmaterial (42) ausgestaltet mit einem vorgeschriebenen Winkel in Bezug auf die Mittelachse des säulenförmigen gestapelten Körpers aufweist, verwendet wird, um die Sauerstoffsperrschicht (70), die thermische Entspannungsschicht (22) und die thermische Sperrschicht (23) zu bilden.

5. Herstellungsverfahren eines keramikbeschichteten Elements nach Anspruch 4, wobei eine oxidationsbeständige Schicht (21), die aus Metall hergestellt ist, zuvor auf einer Oberfläche des Basismaterials (20) gebildet wird.

6. Herstellungsverfahren eines keramikbeschichteten Elements nach Ansprüchen 4 oder 5, wobei der vorgeschriebene Winkel in einem Bereich von 45° bis 85° liegt.

7. Herstellungsverfahren eines keramikbeschichteten Elements nach einem der Ansprüche 4 bis 6, wobei das erste Keramikmaterial einen Wärmeausdehnungskoeffizienten aufweist, der größer ist als jener des zweiten Keramikmaterials.

8. Herstellungsverfahren eines keramikbeschichteten Elements nach einem der Ansprüche 4 bis 7, wobei das erste Keramikmaterial Zirkonoxid als eine Hauptkomponente aufweist und das zweite Keramikmaterial Hafniumoxid als eine Hauptkomponente aufweist.

9. Herstellungsverfahren eines keramikbeschichteten Elements nach Anspruch 4, wobei das dritte Keramikmaterial Aluminiumoxid als eine Hauptkomponente aufweist.

## Revendications

1. Élément recouvert de céramique qui est configuré en stratifiant au moins une couche de barrière d'oxygène (70) ayant de l'oxyde d'aluminium en tant que composant principal, une couche de soulagement de contrainte thermique (22) d'une première matière céramique ayant de l'oxyde de zirconium en tant que composant principal et une couche de barrière thermique (23) d'une deuxième matière céramique ayant de l'oxyde de hafnium en tant que composant principal, dans cet ordre sur une matière de base faite de métal ou de céramique,
dans lequel la quantité de la troisième matière céramique ayant de l'oxyde d'aluminium en tant que composant principal qui forme la couche de barrière d'oxygène (70) diminue de façon continue et la quantité de la première matière céramique qui forme la couche de soulagement de contrainte thermique (22) augmente de façon continue à partir de la couche de barrière d'oxygène (70) vers la couche de soulagement de contrainte thermique (22) dans la couche limitrophe (24) entre la couche de barrière d'oxygène (70) et la couche de soulagement de contrainte thermique (22) ; et
dans lequel la quantité de la première matière céramique qui forme la couche de soulagement de contrainte thermique (22) diminue de façon continue et la quantité de la deuxième matière céramique qui forme la couche de barrière thermique (23) augmente de façon continue à partir de la couche de soulagement de contrainte thermique (22) vers la couche de barrière thermique (23) dans une couche limitrophe entre la couche de soulagement de contrainte thermique (22) et la couche de barrière thermique (23).

2. Élément recouvert de céramique selon la revendication 1, dans lequel une couche résistant à l'oxydation (21) faite de métal est interposée entre la matière de base (20) et la couche de barrière d'oxygène (70).

3. Élément recouvert de céramique selon la revendication 1 ou 2, dans lequel la première matière céramique a un coefficient de dilatation thermique qui est plus grand que celui de la deuxième matière céramique.

4. Procédé de production d'un élément recouvert de céramique selon la revendication 1 par dépôt physique en phase vapeur par faisceau d'électrons en utilisant un lingot (65),
dans lequel le lingot, qui a la troisième matière céramique (66), la première matière céramique (41) et la deuxième matière céramique (42) disposées par empilement de manière colonnaire dans cet ordre pour permettre à la troisième matière céramique (66) sur le côté de s'évaporer en premier et l'interface entre la troisième matière céramique (66) et la première matière céramique (41) et l'interface entre la première matière céramique (41) et la deuxième matière céramique (42) étant configurées à un angle prédéterminé par rapport à l'axe central du corps empilé de manière colonnaire, est utilisé pour former la couche de barrière d'oxygène (70), la couche de soulagement de contrainte thermique (22) et la couche de barrière thermique (23).

5. Procédé de production d'un élément recouvert de céramique selon la revendication 4, dans lequel une couche résistant à l'oxydation (21) faite de métal est formée à l'avance sur une surface de la matière de base (20).

6. Procédé de production d'un élément recouvert de céramique selon les revendications 4 ou 5, dans lequel l'angle prédéterminé est dans une plage de 45° à 85°.

7. Procédé de production d'un élément recouvert de céramique selon l'une quelconque des revendications 4 à 6, dans lequel la première matière céramique a un coefficient de dilatation thermique qui est plus grand que celui de la deuxième matière céramique.

8. Procédé de production d'un élément recouvert de céramique selon l'une quelconque des revendications 4 à 7, dans lequel la première matière céramique a de l'oxyde de zirconium en tant que composant principal et la deuxième matière céramique a de l'oxyde de hafnium en tant que composant principal.

9. Procédé de production d'un élément recouvert de céramique selon la revendication 4, dans lequel la troisième matière céramique a de l'oxyde d'aluminium en tant que composant principal.
